# EUROPEAN PATENT APPLICATION

(11) **EP 4 765 567 A1**
(43) Date of publication of application: **24.06.2026**
(21) Application number: 25851699.6
(22) Date of filing: 23.06.2025
(51) Int. Cl.: H02J 7/00, G01R 31/385, G01R 19/165

(54) **BATTERY SYSTEM AND SYSTEM CONTROL METHOD BASED ON RESETTABLE FUSE LOSS**

(30) Priority: 08.08.2024 KR 20240105884
(71) Applicant: LG Energy Solution, Ltd., Seoul 07335 (KR)
(72) Inventor: CHOI, Jang Hyeok, Daejeon 34122 (KR)
(74) Representative: Plasseraud IP
(86) International application number: PCT/KR2025/008658
(87) International publication number: WO 2026/034791

(57) **Abstract**

A battery system includes: a battery; a resettable fuse that is connected between a first node connected to a positive electrode of the battery and a second node connected to an external connection end and is closed after a predetermined recovery time after the resettable fuse is opened; a fuse compensation circuit that includes an operation switch connected between the first node and the second node and a sensing switch connected between a third node to which a voltage is provided according to a result of comparing a voltage of the second node with a predetermined reference voltage and ground and generates a first sensing voltage by resistance distribution of the voltage of the second node; and a main control unit (MCU) that controls a switching operation of the sensing switch based on the first sensing voltage. The fuse compensation circuit controls a switching operation of the operation switch according to a second sensing voltage according to a voltage of the third node.

## Description

### [Technical Field]

### Cross-reference to related application(s)

This application claims priority to and the benefit of Korean Patent Application No. 10-2024-0105884 filed with the Korean Intellectual Property Office on August 8, 2024, the entire contents of which are incorporated herein by reference.

The present disclosure relates to a battery system and a system control method based on a resettable fuse loss.

### [Background Art]

An overcurrent greater than or equal to a trip current may occur or resistance of a resettable fuse included in a battery system may be significantly increased in a situation where an external device connected to the battery system malfunctions so that a flow of a current is cut off and the resettable fuse is gradually restored to its original state after the flow of the current is cut off. However, because it takes a predetermined recovery time for the resistance to return to its original value after the flow of the current is cut off, a function thereof may not be utilized from a circuit perspective so that a loss occurs.

If the resettable fuse is opened so that the flow of the current is cut off, power is not supplied to the external device so that a quick response to a resettable fuse loss is required.

### [Disclosure]

### [Technical Problem]

The present disclosure is intended to provide a battery system and a system control method based on a resettable fuse loss capable of operating a function of an external device connected to the battery system even during a recovery time of a resettable fuse.

### [Technical Solution]

A battery system according to a feature of the present disclosure includes: a battery; a resettable fuse that is connected between a first node connected to a positive electrode of the battery and a second node connected to an external connection end and is closed after a predetermined recovery time after the resettable fuse is opened; a fuse compensation circuit that includes an operation switch connected between the first node and the second node and a sensing switch connected between a third node to which a voltage is provided according to a result of comparing a voltage of the second node with a predetermined reference voltage and ground and generates a first sensing voltage by resistance distribution of the voltage of the second node; and a main control unit (MCU) that controls a switching operation of the sensing switch based on the first sensing voltage. The fuse compensation circuit controls a switching operation of the operation switch according to a second sensing voltage according to a voltage of the third node.

The sensing switch may include: a source terminal that is connected to the third node; a drain terminal that is connected to the ground; and a gate terminal that receives a switch control signal from the main control unit.

The operation switch may include a first source terminal connected to the first node, a first drain terminal connected to an anode of a diode whose cathode is connected to the second node, and a first gate terminal connected to one end of a resistor, and the fuse compensation circuit may further include another switch including a second drain terminal connected to the other end of the resistor, a second source terminal connected to ground, and a second gate terminal receiving the second sensing voltage.

The fuse compensation circuit may further include a comparator supplying a comparator voltage with a high level to the third node if the voltage of the second node is decreased below the reference voltage.

The main control unit may generate a switch control signal turning on the sensing switch if it is determined that the first sensing voltage exceeds a predetermined first critical voltage that is an upper limit value of a normal voltage range after the first sensing voltage is increased within the normal voltage range, the second sensing voltage may have a low level and the operation switch is turned off if the sensing switch is turned on, and the normal voltage range may be a voltage range of the first sensing voltage under a condition that the resettable fuse is connected.

The main control unit may perform an inspection notification operation to an external device connected to the external connection end if it is determined that the first sensing voltage is less than or equal to a predetermined first critical voltage in each of a predetermined number of times as a result of checking whether the first sensing voltage exceeds the first critical voltage that is an upper limit value of a normal voltage range for the predetermined number of times or more after the first sensing voltage is increased within the normal voltage range, and the normal voltage range may be a voltage range of the first sensing voltage under a condition that the resettable fuse is connected.

A system control method based on a resettable fuse loss of a battery system including a battery and a resettable fuse that is connected between a first node connected to a positive electrode of the battery and a second node connected to an external connection end and is closed after a predetermined recovery time after the resettable fuse is opened according to a feature of the present disclosure includes: comparing, by a comparator, a negative input terminal voltage corresponding to a voltage of the second node with a positive input terminal voltage corresponding to a predetermined reference voltage and providing, by the comparator, a voltage according to a result of the comparison to a third node connected to an output terminal of the comparator; generating, by a fuse compensation circuit including an operation switch connected between the first node and the second node and a sensing switch connected between the third node and ground, a first sensing voltage by resistance distribution of the voltage of the second node; controlling, by the fuse compensation circuit, a switching operation of the operation switch according to a second sensing voltage according to a voltage of the third node; controlling, by a main control unit (MCU), a switching operation of the sensing switch connected between the third node and the ground based on the first sensing voltage; and controlling, by the fuse compensation circuit, the switching operation of the operation switch according to the second sensing voltage.

The sensing switch may include: a source terminal that is connected to the third node; a drain terminal that is connected to the ground; and a gate terminal that receives a switch control signal from the main control unit.

The operation switch may include a first source terminal connected to the first node, a first drain terminal connected to an anode of a diode whose cathode is connected to the second node, and a first gate terminal connected to one end of a resistor, and the second sensing voltage may be input to a second gate terminal of another switch including a second drain terminal connected to the other end of the resistor and a second source terminal connected to ground.

The providing of the voltage according to the result of the comparison to the third node connected to the output terminal of the comparator by the comparator may include supplying a comparator voltage with a high level to the third node if the voltage of the second node is decreased below the reference voltage.

The controlling of the switching operation of the sensing switch by the main control unit may include generating a switch control signal turning on the sensing switch if it is determined that the first sensing voltage exceeds a predetermined first critical voltage that is an upper limit value of a normal voltage range after the first sensing voltage is increased within the normal voltage range, and the normal voltage range may be a voltage range of the first sensing voltage under a condition that the resettable fuse is connected.

The system control method may further include performing, by the main control unit, an inspection notification operation to an external device connected to the external connection end if it is determined that the first sensing voltage is less than or equal to the first critical voltage in each of a predetermined number of times as a result of checking whether the first sensing voltage exceeds the first critical voltage for the predetermined number of times or more after the first sensing voltage is increased within the normal voltage range.

### [Advantageous Effects]

According to the present disclosure, a system function of an external device to which a battery system is connected may be operated even during a recovery time after a resettable fuse is opened. However, it may be difficult to apply a load within the external device in a permanent failure situation.

According to the present disclosure, a main control unit (MCU) may determine states of the fuse and the load through a filter circuit of an operation portion.

According to the present disclosure, if the resettable fuse is opened, the operation portion may be quickly operated to supply power from a battery to an external device through the operation portion.

According to the present disclosure, if the resettable fuse is closed after the operation portion is operated, the operation portion may be reset to supply power from the battery to the external device through the resettable fuse. Therefore, a leakage current may be minimized, and power may be efficiently operated.

According to the present disclosure, an operation sensing circuit may compare a voltage of a second node with a reference voltage to turn on an operation switch connected between a first node and the second node, and the MCU may turn off the operation switch under a predetermined requirement using a first sensing voltage generated by the filter circuit. Thus, the operation sensing circuit may turn on the operation switch according to a voltage comparison result of a comparator regardless of a control of the MCU. Therefore, compared with turning on the operation switch under a control of the MCU, the present disclosure may more quickly supply power from the battery to a system connected to a BMS by accelerating a response time for turning on the operation switch after the resettable fuse is opened.

According to the present disclosure, if the resettable fuse is opened so that a flow of a current is cut off, power may not be supplied to the external device. Thus, the operation portion may be quickly operated to minimize blocking of power supply to an external system.

According to the present disclosure, the MCU may quickly respond to a resettable fuse failure by notifying the external device that an inspection is required if the resettable fuse is not closed for a predetermined time after it is opened.

### [Description of the Drawings]

FIG. 1 is a block diagram schematically illustrating a battery system according to an embodiment of the present disclosure.
FIG. 2 is a timing diagram for describing an operation of the battery system according to an embodiment.
FIG. 3 is a flowchart of a system control method based on a resettable fuse loss according to an embodiment.
FIG. 4 is a flowchart of a system control method in which a repetitive confirmation operation for a reset control of an operation portion is added to the embodiment illustrated in FIG. 3.

### [Mode for Invention]

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and/or "unit, portion, or part" representing a constituent element used in the following description are used only in order to make understanding of the specification easier, and thus, these terms do not have meanings or roles that distinguish them from each other by themselves. In addition, in describing embodiments of the present specification, when it is determined that a detailed description of the well-known art associated with the present disclosure may obscure the gist of the present disclosure, it will be omitted. Further, the accompanying drawings are provided only in order to allow embodiments disclosed in the present specification to be easily understood and should not be interpreted as limiting the spirit disclosed in the present specification, and it should be understood that the present disclosure includes all modifications, equivalents, and substitutions without departing from the scope and spirit of the present disclosure.

Terms including ordinal numbers such as first, second, and the like will be used only to describe various constituent elements, and should not be interpreted as limiting the constituent elements. The terms are only used to differentiate one constituent element from other constituent elements.

In the present application, it should be understood that the term "include", "comprise", "have", or "configure" indicates that a feature, a number, a step, an operation, a constituent element, a part, or a combination thereof described in the specification is present but does not exclude a possibility of presence or addition of one or more other features, numbers, steps, operations, constituent elements, parts, or combinations, in advance.

From among configurations according to an embodiment, a program that is realized with a set of instructions that are an actualized control algorithm for controlling other configurations may be installed in the configuration for controlling the other configurations in a specific control condition. A control configuration may process input data and stored data according to the installed program to generate output data. The control configuration may include a non-volatile memory for storing the program and a memory for storing the data.

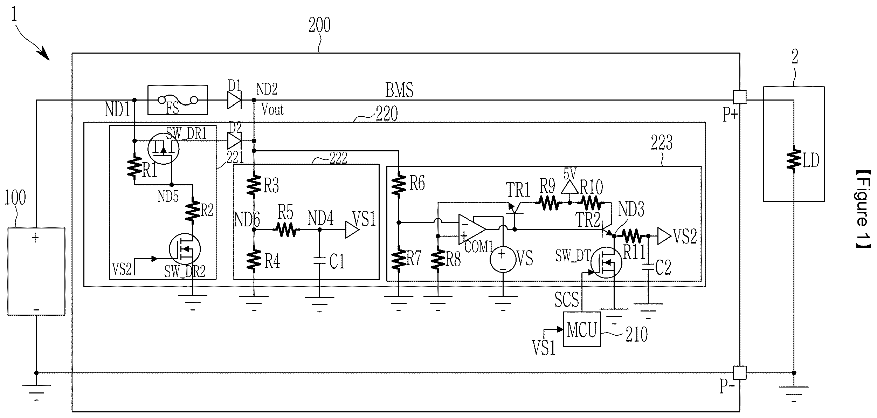

FIG. 1 is a block diagram schematically illustrating a battery system according to an embodiment of the present disclosure.

Referring to FIG. 1, a battery system 1 may include a battery 100 and a battery management system (BMS) 200.

The battery system 1 may be connected to an external device 2. The external device 2 may be a system such as a vehicle or a sensor. Both ends P+ and P- of the battery system 1 may be connected to the external device 2. Hereinafter, for convenience of description, both ends P+ and P- of the battery system 1 may be referred to as external connection ends.

The external device 2 may include a load LD. In FIG. 1, the external device 2 is illustrated as including the load LD, but this is for convenience of description and the present disclosure is not limited thereto. The external device 2 may include the load such as an inverter or a converter or a charging device. If the external device 2 is a charger, both ends P+ and P- of the battery system 1 may be connected to the charger to be charged by receiving electric power from the charger. If the external device 2 is the load, both ends P+ and P- of the battery system 1 may be connected to the load so that power supplied by a battery pack 100 is discharged through the load. The external device 2 may include a vehicle control unit (VCU) included in the vehicle.

A positive electrode of the battery 100 may be connected to the BMS 200, and a negative electrode of the battery 100 may be connected to ground. The battery 100 may be an auxiliary battery of the vehicle.

The BMS 200 may include a main control unit (MCU) 210 and a fuse compensation circuit 220. The BMS 200 may include a fuse FS and a diode D1.

The fuse FS may be a resettable fuse that is connected between a node ND1 and a node ND2 to be closed after a predetermined recovery time after being opened. The resettable fuse may cut off power supplied from the battery 100 to the load LD in a situation where an overcurrent greater than or equal to a trip current occurs or in a malfunction situation. The overcurrent may occur or resistance of the resettable fuse may be significantly increased in the malfunction situation so that a flow of a current is cut off and the resettable fuse is gradually restored to its original state after the flow of the current is cut off. However, because it takes a specific time for the resistance of the resettable fuse to return to its original value, a function of the fuse may not be utilized until the resistance returns.

One end of the fuse FS may be connected to the node ND1, and the other end of the fuse FS may be connected to an anode of the diode D1. A cathode of the diode D1 may be connected to the node ND2.

The node ND1 may be connected to the positive electrode of the battery 100, and the node ND2 may be connected to the external connection end P+. One end of the load LD may be connected to the external connection end P+, and the other end of the load LD may be connected to ground. Referring to FIG. 1, a voltage of the node ND2 may be referred to as an output voltage Vout.

The fuse compensation circuit 220 may include an operation switch SW_DR1 and a sensing switch SW_DT. The fuse compensation circuit 220 may monitor an operation of the fuse FS to provide a current path corresponding to opening of the fuse FS.

The fuse compensation circuit 220 may generate a first sensing voltage VS1 based on the voltage of the node ND2. The voltage of the node ND2 may be divided by two resistors R3 and R4 to determine a voltage of a node ND6, and the voltage of the node ND6 may be filtered by a resistor R5 and a capacitor C1 to determine a voltage of a node ND4. That is, the fuse compensation circuit 220 may generate the first sensing voltage VS1 by performing resistance distribution and filtering on the voltage of the node ND2.

The operation switch SW_DR1 may be connected between the node ND1 and the node ND2. The sensing switch SW_DT may be connected between a node ND3 and ground. The node ND3 may provide a voltage based on a result of comparing the voltage of the node ND2 with a predetermined reference voltage. Hereinafter, the predetermined reference voltage may be an upper limit value of a voltage range of the node ND2 under a condition that the fuse FS is cut off.

The fuse compensation circuit 220 may include an operation portion 221, a filter circuit 222, and an operation sensing circuit 223.

The operation portion 221 may be connected between the node ND1 and the node ND2. The operation portion 221 may provide a power path connecting the node ND1 and the node ND2 according to a second sensing voltage VS2 supplied from the operation sensing circuit 223, and may block the power path according to a control signal supplied from the MCU 210. The second sensing voltage VS2 may depend on a voltage of the node ND3. The fuse compensation circuit 220 may control a switching operation of the operation switch SW_DR1 according to the second sensing voltage VS2.

If the operation switch SW_DR1 is turned on, the operation portion 221 may provide the power path connecting the node ND1 and the node ND2. In an embodiment, the operation portion 221 may provide the power path according to the second sensing voltage VS2. In an embodiment, compared with the MCU 210 sensing a specific voltage to control the switching operation of the operation switch SW_DR1, the operation portion 221 may quickly provide the power path after the fuse FS is opened. For example, the operation portion 221 may provide a power path connecting the battery 100 and the external device 2 within 1 ms from a time point when the fuse FS is opened.

The filter circuit 222 may be connected to the node ND2 to filter the voltage of the node ND2 so that it generates the first sensing voltage VS1 according to the voltage of the node ND2. The filter circuit 222 may convert the voltage of the node ND2 into a voltage within an operation range of the MCU 210 to generate the first sensing voltage VS1. The first sensing voltage VS1 may represent a voltage of the node ND4. The first sensing voltage VS1 may be supplied to the MCU 210.

The MCU 210 may control a switching operation of the sensing switch SW_DT based on the first sensing voltage VS1. The MCU 210 may monitor the first sensing voltage VS1, and may notify the external device 2 that an inspection is required based on the monitoring result. For example, if the first sensing voltage VS1 returns within a normal voltage range after it is determined that the fuse is opened because the first sensing voltage VS1 is reduced to less than a lower limit value of the normal voltage range, the MCU 210 may determine that the load LD returns to a normal state from an abnormal state such as an overcurrent. Hereinafter, the normal voltage range may be a voltage range of the first sensing voltage VS1 under a condition that the fuse FS is connected.

Thus, if it is checked whether the first sensing voltage VS1 is further increased beyond an upper limit value of the normal voltage range for a predetermined number of times or more at predetermined time intervals after the first sensing voltage VS1 returns within the normal voltage range but the further increase is not sensed, the MCU 210 may perform an inspection notification operation to the external device 2. This may be because the fuse FS is not closed again even after a recovery time so that it needs to be inspected if the first sensing voltage VS1 is not further increased beyond the upper limit value of the normal voltage range after the first sensing voltage VS1 returns within the normal voltage range.

The operation portion 221 may include the operation switch SW_DR1, an operation switch SW_DR2, and a plurality of resistors R1 and R2.

In FIG. 1, the operation switch SW_DR1 is illustrated as a p-channel MOSFET, but this is for convenience of description and the present disclosure is not limited thereto. The operation switch SW_DR1 may provide a current path through which an electric current flows from a source terminal thereof to a drain terminal thereof if a voltage difference between a gate terminal thereof and the source terminal thereof is a voltage equal to or less than a predetermined first threshold value.

The source terminal of the operation switch SW_DR1 may be connected to the node ND1 and one end of a resistor R1. The drain terminal of the operation switch SW_DR1 may be connected to an anode of a diode D2. The other end of the resistor R1, the gate terminal of the operation switch SW_DR1, and one end of a resistor R2 may be connected to a node ND5. A cathode of the diode D2 may be connected to the node ND2.

In FIG. 1, the operation switch SW_DR2 is illustrated as an n-channel MOSFET, but this is for convenience of description and the present disclosure is not limited thereto. The operation switch SW_DR2 may provide a current path through which an electric current flows from a drain terminal thereof to a source terminal thereof if a voltage difference between a gate terminal thereof and the source terminal thereof is equal to or greater than a predetermined second threshold value.

The drain terminal of the operation switch SW_DR2 may be connected to the other end of the resistor R2. The source terminal of the operation switch SW_DR2 may be connected to ground. The gate terminal of the operation switch SW_DR2 may receive the second sensing voltage VS2 from the operation sensing circuit 223.

The filter circuit 222 may include the plurality of resistors R3-R5 and the capacitor C1. One end of the resistor R3 may be connected to the node ND2. The other end of the resistor R3, one end of the resistor R4, and one end of the resistor R5 may be connected at the node ND6. The other end of the resistor R4 may be connected to ground. The other end of the resistor R5 and one end of the capacitor C1 may be connected at the node ND4. The other end of the capacitor C1 may be connected to ground. The first sensing voltage VS1 may represent a voltage of the node ND4 between the resistor R5 and the capacitor C1. The first sensing voltage VS1 may be distributed from the voltage of the node ND6 by the resistor R5 and the capacitor C1 to represent a voltage applied to the one end of the capacitor C1. The plurality of resistors R3-R5 may be designed in units of mega ohms or more to minimize a leakage current of the filter circuit 222.

The operation sensing circuit 223 may generate the second sensing voltage VS2 that controls a switching operation of the operation portion 221 based on the voltage of the node ND2 and a switch control signal SCS received from the MCU 210. The operation sensing circuit 223 may include a plurality of resistors R6-R11, a capacitor C2, a comparator COM1, a voltage source VS, a transistor TR1, a transistor TR2, and the sensing switch SW_DT.

The comparator COM1 may compare a negative input terminal (-) voltage with a positive input terminal (+) voltage to output a voltage to an output terminal thereof. Hereinafter, for convenience of description, an output voltage of the comparator COM1 may be referred to as a comparator voltage.

If the voltage of the node ND2 is less than the predetermined reference voltage, a voltage of a negative input terminal (-) of the comparator COM1 may be less than a voltage of a positive input terminal (+) of the comparator COM1. If the negative input terminal (-) voltage corresponding to the voltage of the node ND2 decreases below the positive input terminal (+) voltage corresponding to the predetermined reference voltage, the comparator COM1 may supply the comparator voltage with a high level to the output terminal. The comparator voltage with the high level may be a voltage level capable of turning on the transistor TR1 and the transistor TR2. The comparator voltage with a low level may be a voltage level capable of turning off the transistor TR1 and the transistor TR2.

If the comparator voltage with the high level is supplied to the output terminal of the comparator COM1, the transistor TR1 and the transistor TR2 may be turned on so that the comparator COM1 supplies the comparator voltage with the high level to the node ND3 if the voltage of the node ND2 decreases below the predetermined reference voltage.

One end of the resistor R6 may be connected to the node ND2. The other end of the resistor R6 and one end of the resistor R7 may be connected to the negative input terminal (-) of the comparator COM1. The other end of the resistor R7 may be connected to ground. The resistor R8 may be connected between the positive input terminal (+) of the comparator COM1 and ground. An emitter terminal of the transistor TR1 may be connected to the positive input terminal (+) of the comparator COM1. A collector terminal of the transistor TR2 may be connected to one end of the resistor R9. A voltage of 5V may be provided to a node where the other end of the resistor R9 and one end of the resistor R10 are connected. The other end of the resistor R10 may be connected to the collector terminal of the transistor TR2. A base terminal of the transistor TR2 may be connected to the output terminal of the comparator COM1. An emitter terminal of the transistor TR2 may be connected to the node ND3.

Hereinafter, the voltage of 5V connected to the node where the other end of the resistor R9 and one end of the resistor R10 are connected may be referred to as a 5V voltage source. In FIG. 1, the 5V voltage source is shown as being connected between the resistor R9 and the resistor R10, but a voltage value of the 5 V voltage source is only an example and the present disclosure is not limited thereto.

A source terminal of the sensing switch SW_DT may be connected to the node ND3. A drain terminal of the sensing switch SW_DT may be connected to ground. A gate terminal of the sensing switch SW_DT may receive the switch control signal SCS from the MCU 210.

One end of the resistor R11 may be connected to the node ND3. The capacitor C2 may be connected to the other end of the resistor R11. The transistor TR2 and the sensing switch SW_DT may be connected to the node ND3 to generate the second sensing voltage VS2 according to the voltage of the node ND3. The second sensing voltage VS2 may represent a voltage of a node between the resistor R11 and the capacitor C2. The second sensing voltage VS2 may be distributed from the voltage of the node ND3 by the resistor R11 and the capacitor C2 to represent a voltage applied to one end of the capacitor C2.

The second sensing voltage VS2 may be supplied to the gate terminal of the operation switch SW_DR2 of the operation portion 221.

In FIG. 1, each of the transistor TR1 and the transistor TR2 is illustrated as an NPN type transistor, but this is for convenience of description and the present disclosure is not limited thereto. In FIG. 1, the sensing switch SW_DT is illustrated as an n-channel MOSFET, but this is for convenience of description and the present disclosure is not limited thereto. The sensing switch SW_DT may provide a current path through which an electric current flows from a drain terminal thereof to a source terminal thereof if a voltage difference between a gate terminal thereof and the source terminal thereof is equal to or greater than a predetermined third threshold value.

The transistor TR1 may provide a current path through which an electric current flows from the 5V voltage source to the positive input terminal (+) of the comparator COM1 if the comparator voltage has the high level. The transistor TR2 may provide a current path through which an electric current flows from the 5V voltage source to the node ND3 if the comparator voltage has the high level.

If the voltage of the node ND2 decreases below the predetermined reference voltage, the negative input terminal (-) voltage of the comparator COM1 may be lower than the positive input terminal (+) voltage of the comparator COM1. If the negative input terminal (-) voltage of the comparator COM1 is lower than the positive input terminal (+) voltage of the comparator COM1, the comparator voltage with the high level may be generated at the output terminal of the comparator COM1 so that the transistor TR1 and the transistor TR2 are turned on.

Each of the transistor TR1 and the transistor TR2 may be operated in a saturation mode if they are turned on.

If the negative input terminal (-) voltage of the comparator COM1 is greater than or equal to the positive input terminal (+) voltage of the comparator COM1, the output terminal of the comparator COM1 may not generate the comparator voltage (for example, the comparator voltage may be 0 V), or may generate the comparator voltage with the low level. If the negative input terminal (-) voltage of the comparator COM1 is greater than or equal to the positive input terminal (+) voltage of the comparator COM1, the transistor TR1 and the transistor TR2 may not be turned on, and may be maintained in an off state. Hereinafter, that the operation sensing circuit 223 is operated may indicate that the transistor TR1 and the transistor TR2 are turned on and the sensing switch SW_DT is turned off.

If the voltage of the node ND2 decreases below the predetermined reference voltage after the fuse FS is opened, the comparator voltage with the high level may be generated at the output terminal of the comparator COM1 so that the operation sensing circuit 223 is operated. If the operation sensing circuit 223 is operated, a level of the second sensing voltage VS2 may be switched to a high level. If the second sensing voltage VS2 has the high level, the operation switch SW_DR2 that receives the second sensing voltage VS2 at a gate terminal thereof may be turned on. The second sensing voltage VS2 with the high level may be a voltage level capable of turning on the operation switch SW_DR2. The second sensing voltage VS2 with a low level may be a voltage level capable of turning off the operation switch SW_DR2.

If the second sensing voltage VS2 is converted to the high level, the voltage of the node ND3 may be held to a high level. Thus, after the second sensing voltage VS2 is converted to the high level, in order to convert the second sensing voltage VS2 to the low level, it is necessary to bypass the voltage of the node ND3 to ground through the sensing switch SW_DT. In the present specification, for convenience of description, an operation of resetting the operation portion 221 may refer to an operation of bypassing the voltage of the node ND3 to the ground through the sensing switch SW_DT after the second sensing voltage VS2 is converted to the high level.

If the operation switch SW_DR2 is turned on, a current path connecting the resistor R1, the resistor R2, the operation switch SW_DR2, and the ground may be formed. If the operation switch SW_DR2 is turned on so that the current path connecting the resistor R1, the resistor R2, the operation switch SW_DR2, and the ground is formed, the operation switch SW_DR1 may be turned on. If the operation switch SW_DR1 is turned on, a power path including the node ND1, the operation switch SW_DR1, the diode D2, and the node ND2 may be formed. Therefore, if the operation sensing circuit 223 is operated, the operation switch SW_DR1 and the operation switch SW_DR2 may be turned on so that the operation portion 221 provides a power path from the battery 100 to the external connection ends P+ and P- through the operation switch SW_DR1 and the diode D2.

Hereinafter, that the operation portion 221 is operated may indicate that the operation switch SW_DR1 and the operation switch SW_DR2 are turned on. If the operation portion 221 is operated, power supplied from the battery 100 may be supplied to the load LD through the fuse compensation circuit 220.

The MCU 210 may generate the switch control signal SCS based on the first sensing voltage VS1. The MCU 210 may generate the switch control signal SCS that controls a switching operation of the sensing switch SW_DT according to the first sensing voltage VS1, and may provide the switch control signal SCS to the fuse compensation circuit 220. The MCU 210 may transmit the switch control signal SCS to the gate terminal of the sensing switch SW_DT.

If it is determined that the fuse FS is closed so that the first sensing voltage VS1 exceeds a predetermined first critical voltage after the operation portion 221 is operated, the MCU 210 may generate a control signal for turning on the sensing switch SW_DT as the switch control signal SCS. The predetermined first critical voltage may be an upper limit of the normal voltage range that is the voltage range of the first sensing voltage VS1 under the condition that the fuse FS is connected. In this case, a lower limit of the normal voltage range may be referred to as a second critical voltage. For example, if the normal voltage range is 3.9 V or more and 4.1 V or less, the first critical voltage may be 4.1 V and the second critical voltage may be 3.9 V.

When the voltage of the node ND2 is the predetermined reference voltage, the first sensing voltage VS1 may be referred to as a third critical voltage. For example, the third critical voltage may be 0.1 V. The predetermined reference voltage may be a maximum voltage for allowing an output of the comparator COM1 to become a high level. The third critical voltage may be a voltage lower than the second critical voltage.

If a value of the first sensing voltage VS1 is increased within the normal voltage range after the operation portion 221 is operated, the MCU 210 may determine that a state of the load LD returns from an overcurrent state to a normal state. If the first sensing voltage VS1 exceeds the first critical voltage after the operation portion 221 is operated and the first sensing voltage VS1 is increased within the normal voltage range, the MCU 210 may determine that a recovery time of the fuse FS elapses so that the fuse FS is closed. If the recovery time of the fuse FS elapses so that the fuse FS is closed after the fuse FS is opened, the fuse FS, not the operation portion 221, needs to provide a power path between the battery 100 and the external connection end P+. Therefore, if it is determined that the recovery time of the fuse FS elapses so that the fuse FS is closed, the MCU 210 may turn on the sensing switch SW_DT to stop an operation of the operation portion 221. For example, if it is determined that the first sensing voltage VS1 is increased from 0 V to 4 V at a second time point after a first time point and is further increased from 4 V to 4.2 V after the second time point, the MCU 210 may stop an operation of the operation sensing circuit 223.

Hereinafter, for convenience of description, that the MCU 210 converts the switch control signal SCS to a high level may be referred to as a reset control of the operation portion. The reset control of the operation portion may include an operation in which the operation sensing circuit 223 transmits a signal for stopping the operation of the operation portion 221 (i.e., the second sensing voltage VS2 with the low level) to the operation portion 221.

The switch control signal SCS with a high level may be a voltage level capable of turning on the sensing switch SW_DT. The switch control signal SCS with a low level may be a voltage level capable of turning off the sensing switch SW_DT.

The MCU 210 may transmit the switch control signal SCS with the high level to the gate terminal of the sensing switch SW_DT to stop the operation of the operation sensing circuit 223. If the MCU 210 transmits the switch control signal SCS with the high level to the gate terminal of the sensing switch SW_DT, the sensing switch SW_DT may be turned on.

If the sensing switch SW_DT is turned on, a current path connecting the node ND3 to ground may be formed. If the sensing switch SW_DT is turned on, the operation sensing circuit 223 may stop its operation so that a level of the second sensing voltage VS2 is switched to a low level. If the second sensing voltage VS2 has the low level, the operation switch SW_DR2 that receives the second sensing voltage VS2 at a gate terminal thereof may be turned off.

If the operation switch SW_DR2 is turned off, the current path connecting the resistor R1, the resistor R2, the operation switch SW_DR2, and the ground may be blocked. If the operation switch SW_DR2 is turned off so that the current path connecting the resistor R1, the resistor R2, the operation switch SW_DR2, and the ground is blocked, the operation switch SW_DR1 may be turned off. If the operation switch SW_DR1 is turned off, the power path including the node ND1, the operation switch SW_DR1, the diode D2, and the node ND2 may be blocked. Therefore, if the operation sensing circuit 223 is not operated, the operation switch SW_DR1 and the operation switch SW_DR2 may be turned off so that the operation portion 221 stops its operation. Hereinafter, for convenience of description, that the operation switch SW_DR1 and the operation switch SW_DR2 are turned off may be referred to as stop of an operation of the operation portion.

If the operation of the operation portion 221 is stopped, the operation portion 221 may block the power path from the battery 100 to the external connection ends P+ and P- through the operation switch SW_DR1 and the diode D2. In other words, if the MCU 210 controls resetting of the operation portion, the operation of the operation portion 221 may be stopped.

The sensing switch SW_DT may maintain an on state for a predetermined holding time from a time point when it is turned on, and may be turned off if the holding time elapses. The predetermined holding time may be a sufficient time required from a time point when the sensing switch SW_DT is turned on until the operation switch SW_DR1 and the operation switch SW_DR2 are turned off. For example, the MCU 210 may switch a level of the switch control signal SCS to a low level at a time point when the predetermined holding time elapses from a time point when the MCU 210 switches a level of the switch control signal SCS to a high level.

If it is determined that the first sensing voltage VS1 exceeds the first critical voltage for a predetermined number of times or more at predetermined time intervals but does not exceed the first critical voltage after the operation portion 221 is operated and the value of the first sensing voltage VS1 is increased within the normal voltage range, the MCU 210 may perform an inspection notification operation to the external device 2.

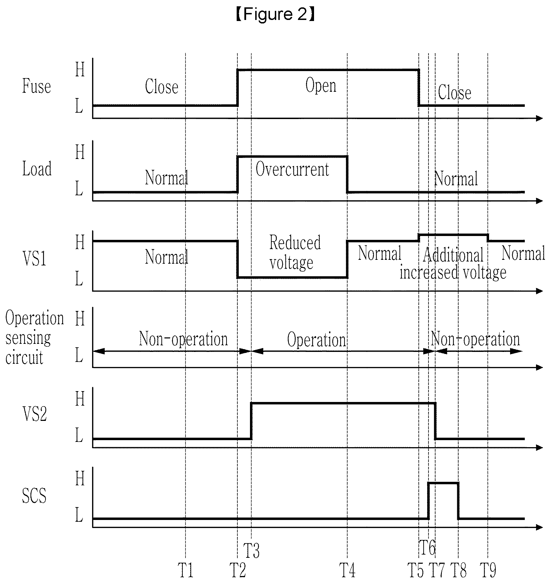

FIG. 2 is a timing diagram for describing an operation of the battery system according to an embodiment.

Hereinafter, a level of the first sensing voltage VS1, an operation of the operation sensing circuit 223, a level of the second sensing voltage VS2, and a level of the switch control signal SCS according to whether the fuse FS is tripped and whether an overcurrent flows through the load LD will be described with reference to FIG. 2.

If the fuse FS is closed and the load LD is normally operated at a time point T1, the first sensing voltage VS1 may represent a high level within the normal voltage range. For example, at a time point from the time point T1 to a time point T2, the first sensing voltage VS1 may represent 4 V.

If an overcurrent flows through the load LD at a time point from the time point T2 to a time point T3, the fuse FS may be opened so that the first sensing voltage VS1 represents a low level at which a voltage is reduced. The low level may be less than the third critical voltage. For example, the low level of the first sensing voltage VS1 may be 0 V.

Because the fuse FS is opened so that the voltage of the node ND2 is reduced below the predetermined reference voltage at the time point from the time point T2 to the time point T3, the negative input terminal (-) voltage of the comparator COM1 may be lower than the positive input terminal (+) voltage of the comparator COM1. Thus, the comparator voltage with the high level may be generated at the output terminal of the comparator COM1 so that the operation sensing circuit 223 is operated. If the operation sensing circuit 223 is operated, a level of the second sensing voltage VS2 may be switched to a high level. If the second sensing voltage VS2 has the high level, the operation switch SW_DR2 that receives the second sensing voltage VS2 at a gate terminal thereof may be turned on.

If the operation switch SW_DR2 is turned on, the operation switch SW_DR1 may be also turned on so that the operation portion 221 is operated, and the operation portion 221 may provide a power path from the battery 100 to the external connection ends P+ and P- through the operation switch SW_DR1 and the diode D2. If the operation portion 221 is operated, power supplied from the battery 100 may be supplied to the load LD through the fuse compensation circuit 220.

If the load LD is operated normally again at a time point T4, the first sensing voltage VS1 may again indicate a high level within the normal voltage range. For example, at a time point from the time point T4 to a time point T5, the first sensing voltage VS1 may be 4 V.

If the fuse FS is closed during a normal operation of the load LD at a time point from the time point T5 to a time point T6, the first sensing voltage VS1 may exceed the first critical voltage. For example, the first sensing voltage VS1 may be 4.2 V at a time point from the time point T5 to a time point T9.

If it is determined that the first sensing voltage VS1 exceeds the first critical voltage that is the upper limit of the normal voltage range after the first sensing voltage VS1 is increased from the low level to the normal voltage range, the MCU 210 may generate the switch control signal SCS with the high level at the time point T6. If the MCU 210 transmits the switch control signal SCS with the high level to the gate terminal of the sensing switch SW_DT, the sensing switch SW_DT may be turned on.

If the sensing switch SW_DT is turned on at a time point from the time point T6 to a time point T7, the operation sensing circuit 223 may stop its operation. If the operation sensing circuit 223 stops its operation, a level of the second sensing voltage VS2 may be switched to a low level. If the second sensing voltage VS2 has the low level, the operation switch SW_DR2 may be turned off. If the operation switch SW_DR2 is turned off, the operation switch SW_DR1 may be also turned off so that the operation portion 221 stops its operation. If the operation of the operation portion 221 is stopped, the operation portion 221 may block the power path from the battery 100 to the external connection ends P+ and P- through the operation switch SW_DR1 and the diode D2.

At a time point from the time point T7 to a time point T8, the MCU 210 may switch a level of the switch control signal SCS to the low level after a predetermined holding time elapses from a time point when it switches a level of the switch control signal SCS to the high level. While the switch control signal SCS has the high level, the sensing switch SW_DT may maintain an on state. If the sensing switch SW_DT is turned on by the switch control signal SCS with the high level, the operation sensing circuit 223 may stop its operation so that the level of the second sensing voltage VS2 is switched to the low level. If the second sensing voltage VS2 has the low level, the operation portion 221 may stop its operation.

At the time point T9, the first sensing voltage VS1 may be lowered from a voltage exceeding the first critical voltage within the normal voltage range.

As described above, because the fuse FS is closed after a predetermined recovery time from a time point when the fuse FS is opened and power is not supplied to the load LD through the fuse FS while the fuse FS is opened, the operation portion 221 may be operated according to the operation sensing circuit 223 and a control of the MCU 210.

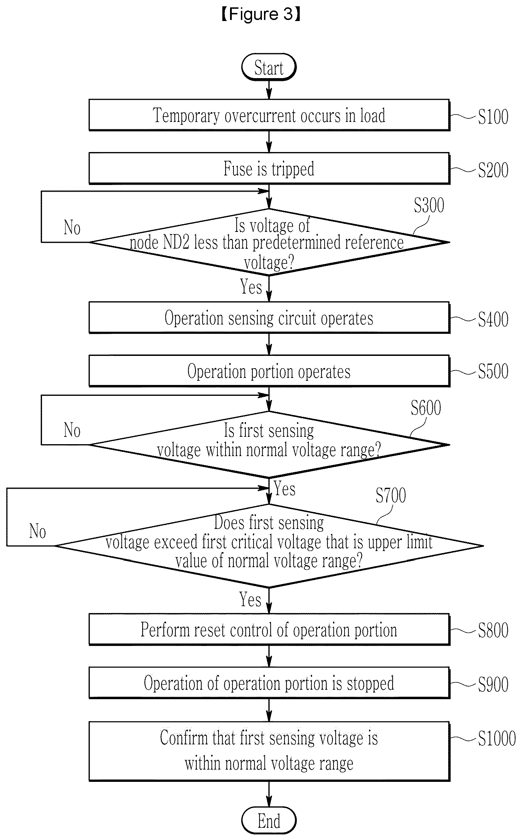

FIG. 3 is a flowchart of a system control method based on a resettable fuse loss according to an embodiment.

Hereinafter, a description of each component of the BMS 200 that overlaps the above description may be omitted.

Referring to FIG. 3, a temporary overcurrent may occur in the load LD (S100). In FIG. 3, it is described that the temporary overcurrent occurs in the load LD, but this is only for convenience of description and the present disclosure is not limited thereto. In some embodiments, the step S100 may indicate a case where the overcurrent greater than or equal to the trip current occurs or the resistance of the resettable fuse is significantly increased in the malfunction situation or the like.

After the step S100, the fuse FS may be tripped to an open state (S200).

After the step S200, if the voltage of the node ND2 is reduced below the predetermined reference voltage (Yes in a step S300), the comparator COM1 may generate the comparator voltage with the high level to operate the operation sensing circuit (S400). If the voltage of the node ND2 is not reduced below the predetermined reference voltage in the step S300, the step S300 may be repeated.

After the step S400, because the second sensing voltage VS2 has the high level if the operation sensing circuit 223 is operated, the operation portion 221 may be operated (S500).

After the step S500, the MCU 210 may determine whether the first sensing voltage VS1 is within the normal voltage range (S600). If the MCU 210 determines that the first sensing voltage VS1 is not increased within the normal voltage range in the step S600 after the step S500, the step S600 may be repeated.

If the first sensing voltage VS1 is determined to be within the normal voltage range in the step S600, the MCU 210 may determine whether the first sensing voltage VS1 exceeds the first critical voltage that is the upper limit of the normal voltage range (S700). If it is determined in the step S700 that the first sensing voltage VS1 is less than or equal to the first critical voltage, the MCU 210 may repeat the step S700. A period in which the step S700 is repeated may be a predetermined time interval.

If it is determined in the step S700 that the first sensing voltage VS1 exceeds the first critical voltage, the MCU 210 may generate the switch control signal SCS with the high level to perform the reset control of the operation portion (S800).

After the step S800, if the sensing switch SW_DT is turned on by the reset control of the operation portion, the operation sensing circuit 223 may stop its operation so that a level of the second sensing voltage VS2 is switched to the low level. Thus, the operation switch SW_DR2 may be turned off so that the operation of the operation portion 221 is stopped (S900).

After the step S900, the MCU 210 may confirm that the first sensing voltage VS1 is within the normal voltage range (S1000).

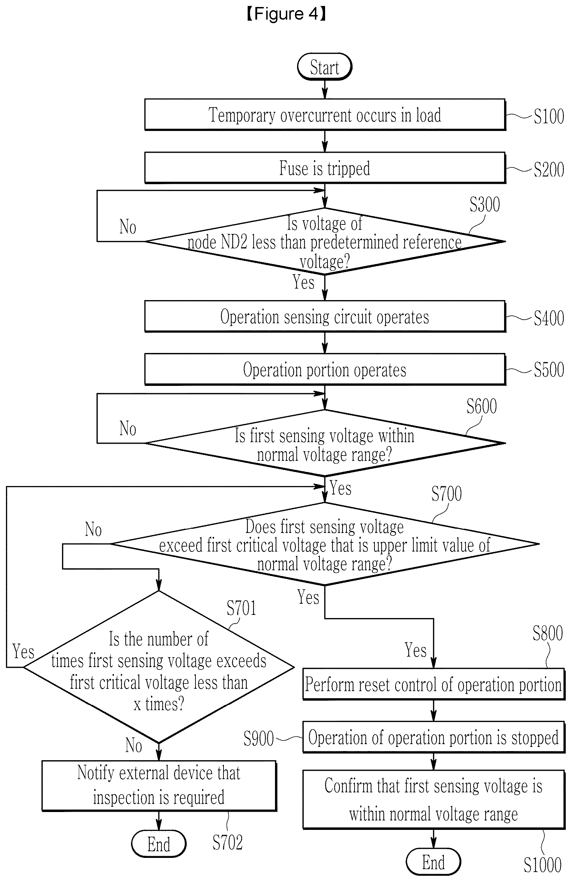

FIG. 4 is a flowchart of a system control method in which a repetitive confirmation operation for the reset control of the operation portion is added to the embodiment illustrated in FIG. 3.

Hereinafter, a description of each component of the BMS 200 that overlaps the above description may be omitted. Additionally, unless otherwise stated, the descriptions for the steps S100 to S600 illustrated in FIG. 3 may be similarly applied to steps S100 to S600 illustrated in FIG. 4.

Referring to FIG. 4, if the first sensing voltage VS1 is determined to be within the normal voltage range in the step S600, the MCU 210 may determine whether the first sensing voltage VS1 exceeds the first critical voltage that is the upper limit of the normal voltage range (S700).

If it is determined in the step S700 that the first sensing voltage VS1 is less than or equal to the first critical voltage, the MCU 210 may determine whether the number of times the first sensing voltage VS1 exceeds the first critical voltage is less than x times (S701). Here, x may be a natural number greater than or equal to 1, and may be a value stored in the BMS 200 that is predetermined as the maximum number of times of an additional increase in the first sensing voltage VS1.

If the number of times the first sensing voltage VS1 exceeds the first critical voltage is less than x times in the step S701, the step S700 may be performed.

If the number of times the first sensing voltage VS1 exceeds the first critical voltage in the step S701 is x times or more, the MCU 210 may notify the external device 2 that an inspection is required (S702).

if it is determined in the step S700 that the first sensing voltage VS1 exceeds the first critical voltage, the MCU 210 may generate the switch control signal SCS with the high level to perform a reset control of the operation portion (S800).

After the step S800, if the sensing switch SW_DT is turned on by the reset control of the operation portion, the operation sensing circuit 223 may stop its operation so that a level of the second sensing voltage VS2 is switched to the low level. Thus, the operation switch SW_DR2 may be turned off so that an operation of the operation portion 221 is stopped (S900).

After the step S900, the MCU 210 may confirm that the first sensing voltage VS1 is within the normal voltage range (S1000).

While this disclosure has been described in connection with what is presently considered to be practical embodiments, it should be understood that the disclosure is not limited to the disclosed embodiments, but, on the contrary, is intended to cover various modifications and equivalent arrangements included within the spirit and scope of the appended claims.

## Claims

1. A battery system comprising:
a battery;
a resettable fuse that is connected between a first node connected to a positive electrode of the battery and a second node connected to an external connection end and is closed after a predetermined recovery time after the resettable fuse is opened;
a fuse compensation circuit that includes an operation switch connected between the first node and the second node and a sensing switch connected between a third node to which a voltage is provided according to a result of comparing a voltage of the second node with a predetermined reference voltage and ground and generates a first sensing voltage by resistance distribution of the voltage of the second node; and
a main control unit (MCU) that controls a switching operation of the sensing switch based on the first sensing voltage,
wherein the fuse compensation circuit controls a switching operation of the operation switch according to a second sensing voltage according to a voltage of the third node.

2. The battery system of claim 1, wherein the sensing switch comprises:
a source terminal that is connected to the third node;
a drain terminal that is connected to the ground; and
a gate terminal that receives a switch control signal from the main control unit.

3. The battery system of claim 1, wherein the operation switch includes a first source terminal connected to the first node, a first drain terminal connected to an anode of a diode whose cathode is connected to the second node, and a first gate terminal connected to one end of a resistor, and the fuse compensation circuit further includes another switch including a second drain terminal connected to the other end of the resistor, a second source terminal connected to ground, and a second gate terminal receiving the second sensing voltage.

4. The battery system of claim 1, wherein the fuse compensation circuit further includes a comparator supplying a comparator voltage with a high level to the third node if the voltage of the second node is decreased below the reference voltage.

5. The battery system of claim 1, wherein the main control unit generates a switch control signal turning on the sensing switch if it is determined that the first sensing voltage exceeds a predetermined first critical voltage that is an upper limit value of a normal voltage range after the first sensing voltage is increased within the normal voltage range, the second sensing voltage has a low level and the operation switch is turned off if the sensing switch is turned on, and the normal voltage range is a voltage range of the first sensing voltage under a condition that the resettable fuse is connected.

6. The battery system of claim 1, wherein the main control unit performs an inspection notification operation to an external device connected to the external connection end if it is determined that the first sensing voltage is less than or equal to a predetermined first critical voltage in each of a predetermined number of times as a result of checking whether the first sensing voltage exceeds the first critical voltage that is an upper limit value of a normal voltage range for the predetermined number of times or more after the first sensing voltage is increased within the normal voltage range, and the normal voltage range is a voltage range of the first sensing voltage under a condition that the resettable fuse is connected.

7. A system control method based on a resettable fuse loss of a battery system including a battery and a resettable fuse that is connected between a first node connected to a positive electrode of the battery and a second node connected to an external connection end and is closed after a predetermined recovery time after the resettable fuse is opened, comprising:
comparing, by a comparator, a negative input terminal voltage corresponding to a voltage of the second node with a positive input terminal voltage corresponding to a predetermined reference voltage and providing, by the comparator, a voltage according to a result of the comparison to a third node connected to an output terminal of the comparator;
generating, by a fuse compensation circuit including an operation switch connected between the first node and the second node and a sensing switch connected between the third node and ground, a first sensing voltage by resistance distribution of the voltage of the second node;
controlling, by the fuse compensation circuit, a switching operation of the operation switch according to a second sensing voltage according to a voltage of the third node;
controlling, by a main control unit (MCU), a switching operation of the sensing switch connected between the third node and the ground based on the first sensing voltage; and
controlling, by the fuse compensation circuit, the switching operation of the operation switch according to the second sensing voltage.

8. The system control method of claim 7, wherein the sensing switch comprises:
a source terminal that is connected to the third node;
a drain terminal that is connected to the ground; and
a gate terminal that receives a switch control signal from the main control unit.

9. The system control method of claim 7, wherein the operation switch includes a first source terminal connected to the first node, a first drain terminal connected to an anode of a diode whose cathode is connected to the second node, and a first gate terminal connected to one end of a resistor, and the second sensing voltage is input to a second gate terminal of another switch including a second drain terminal connected to the other end of the resistor and a second source terminal connected to ground.

10. The system control method of claim 7, wherein the providing of the voltage according to the result of the comparison to the third node connected to the output terminal of the comparator by the comparator includes supplying a comparator voltage with a high level to the third node if the voltage of the second node is decreased below the reference voltage.

11. The system control method of claim 7, wherein the controlling of the switching operation of the sensing switch by the main control unit includes generating a switch control signal turning on the sensing switch if it is determined that the first sensing voltage exceeds a predetermined first critical voltage that is an upper limit value of a normal voltage range after the first sensing voltage is increased within the normal voltage range, and the normal voltage range is a voltage range of the first sensing voltage under a condition that the resettable fuse is connected.

12. The system control method of claim 11, further comprising performing, by the main control unit, an inspection notification operation to an external device connected to the external connection end if it is determined that the first sensing voltage is less than or equal to the first critical voltage in each of a predetermined number of times as a result of checking whether the first sensing voltage exceeds the first critical voltage for the predetermined number of times or more after the first sensing voltage is increased within the normal voltage range.
